# FASCICULE DE BREVET EUROPEEN

(11) **EP 3 011 603 B1**
(45) Date de publication et mention de la délivrance du brevet: **22.03.2017**
(21) Numéro de dépôt: 14733128.4
(22) Date de dépôt: 19.06.2014
(51) Int. Cl.: H01L 33/00, H01L 33/12, H01L 21/02, H01L 33/16, H01L 33/24, H01L 33/18, H01L 33/08

(54) **PROCÉDÉ DE FABRICATION D'UNE STRUCTURE SEMICONDUCTRICE ET COMPOSANT SEMICONDUCTEUR COMPORTANT UNE TELLE STRUCTURE SEMICONDUCTRICE**
VERFAHREN ZUR HERSTELLUNG EINER HALBLEITERSTRUKTUR UND HALBLEITERKOMPONENTE MIT SOLCH EINER HALBLEITERSTRUKTUR
METHOD FOR MANUFACTURING A SEMICONDUCTOR STRUCTURE AND SEMICONDUCTOR COMPONENT COMPRISING SUCH A SEMICONDUCTOR STRUCTURE

(30) Priorité: 21.06.2013 FR 1355923
(43) Date de publication de la demande: 27.04.2016
(73) Titulaire: Commissariat à l'Énergie Atomique et aux Énergies Alternatives, 75015 Paris (FR)
(72) Inventeur: AMSTATT, Benoît, F-38000 Grenoble (FR); DAUDIN, Bruno-Jules, F-38700 La Tronche (FR)
(74) Mandataire: Brevalex
(86) Numéro de dépôt international: PCT/EP2014/062945
(87) Numéro de publication internationale: WO 2014/202722

(56) Documents cités:
- WO-A1-2011/162715
- US-B1- 6 524 932
- CERVANTES-CONTRERAS M ET AL: "Molecular beam epitaxial growth of GaN on (100)- and (111) Si substrates coated with a thin SiC layer", JOURNAL OF CRYSTAL GROWTH, ELSEVIER, AMSTERDAM, NL, vol. 227-228, 1 juillet 2001 (2001-07-01), pages 425-430, XP004250871, ISSN: 0022-0248, DOI: 10.1016/S0022-0248(01)00737-0
- WANG D ET AL: "Si-doped cubic GaN grown on a Si(001) substrate with a thin flat SiC buffer layer", APPLIED PHYSICS LETTERS, AMERICAN INSTITUTE OF PHYSICS, US, vol. 80, no. 14, 8 avril 2002 (2002-04-08) , pages 2472-2474, XP012030494, ISSN: 0003-6951, DOI: 10.1063/1.1467971

## Description

### DOMAINE TECHNIQUE

L'invention se rapporte au domaine des structures semiconductrices et des procédés de fabrication de telles structures

Dans le but d'améliorer les performances des composants semiconducteurs, les recherches à ce sujet se sont focalisées sur les structures de tailles micrométriques, voire nanométriques.

En effet, l'utilisation de telles structures procure plusieurs avantages. Parmi ceux-ci, on peut notamment citer le fait que de telles structures offrent la possibilité de développer des composants qui ne sont plus planaires mais à trois dimensions. Ainsi, on augmente significativement la surface fonctionnelle du composant sans augmentation significative de ses dimensions. Ceci est particulièrement le cas des fils semiconducteurs.

Parmi les axes de recherche sur ces structures, et notamment sur les fils semiconducteurs, l'optimisation des procédés permettant leur fabrication de manière contrôlée reste prioritaire.

Ainsi, l'invention concerne particulièrement un procédé de fabrication d'une structure semiconductrice et un composant semiconducteur comportant une telle structure.

### ÉTAT DE LA TECHNIQUE ANTÉRIEURE

Les procédés de fabrication contrôlés de structures semiconductrices telles que les fils de nitrure de gallium (GaN) doivent prendre en compte les contraintes liées aux matériaux les constituant, ainsi que celles liées au type de structures semiconductrices et aux matériaux composant le support.

Ainsi, un procédé de fabrication de structures comprenant du gallium (Ga), telles que des fils semiconducteurs en nitrure de gallium (GaN), sur une surface comportant du silicium (Si) reste particulièrement problématique dans la mesure où un phénomène de gravure du silicium (Si) par le gallium (Ga) entre en compétition avec le phénomène de cristallisation du matériau à déposer.

Il en résulte que pour la formation de structures comportant du gallium (Ga) sur une surface de silicium (Si), il est nécessaire soit de préalablement protéger la surface du support avec une couche de protection de nitrure d'aluminium (AIN) qui présente l'inconvénient d'être peu conductrice puisque présentant une largeur de bande interdite de 6,3 eV, soit de rechercher les conditions de croissance spécifiquement adaptées aux structures à former. Ces deux solutions restent peu idéales, la première ne permettant pas la formation d'un bon contact électrique entre le support et les structures formées et la deuxième nécessitant une longue procédure d'adaptation pour chaque type de structure à former.

Les documents WO2011/162715A1, US6524932B1 et la publication "Molecular beam epitaxial growth of GaN on (100)- and (111) Si substrates coated with a thin SiC layer", M. Cervantes-Contreras et al, Journal of Crystal Growth 227-228, (2001), DOI: 10.1016/S0022-0248(01)00737-0 décrivent des procédés connus de l'art antérieur.

### EXPOSÉ DE L'INVENTION

La présente invention vise à remédier à ces inconvénients.

Un but de l'invention est donc de fournir un procédé de fabrication d'une structure semiconductrice à la surface d'un support, la structure comportant du gallium et la surface du support comprenant du silicium, ne présentant pas les problèmes inhérents à l'utilisation d'une couche de nucléation de nitrure d'aluminium (AIN) et ne nécessitant pas de longues procédures d'adaptation.

A cet effet, l'invention concerne un procédé de fabrication d'au moins une structure semiconductrice comportant les étapes suivantes :
- fourniture d'un substrat comportant au moins une surface de silicium semiconducteur,
- formation d'une couche de carbure de silicium amorphe en contact avec au moins une partie de la surface de silicium semiconducteur,
- formation de l'au moins une structure semiconductrice en contact avec la couche de carbure de silicium, ladite structure comportant au moins une partie, qui est dite partie de contact, en contact avec la surface de la couche de carbure de silicium, qui comporte du gallium.

Une couche de carbure de silicium est qualifiée d'amorphe lorsqu'elle présente une figure de diffraction en microscopie d'électron en transmission, en correspondance avec la couche en elle-même, comportant un ou plusieurs anneaux diffus ou taches diffuses.

Dans le cas où elle comporte quelques zones cristallines, la figure de diffraction en microscopie d'électron en transmission correspondante présente des taches de diffraction associées aux cristaux ainsi qu'un ou plusieurs anneaux diffus ou taches diffuses associés aux parties amorphes de la couche.

On entend, ici par « en correspondance avec la couche en elle-même », que les pics de diffraction correspondant à d'autres matériaux que celui de la couche en question, tels que celui du substrat, ne sont pas à prendre en compte pour qualifier la couche de carbure de silicium.

Un tel procédé permet la formation d'une structure semiconductrice présentant un contact électrique amélioré vis-à-vis d'une structure semiconductrice formée selon un procédé de l'art antérieur faisant appel à une couche tampon de nitrure d'aluminium (AIN), ceci sans nécessiter de longues procédures d'adaptation. En effet, le carbure de silicium (SiC), lorsqu'il est sous une forme amorphe, présente, comme l'ont montré les travaux de Losurdo et al. publiés en 2005 dans la revue scientifique « Journal of Applied Physics » N°97, pages 103504, une largeur de bande interdite de 2,5 eV, soit une largeur de bande interdite plus de deux fois inférieure à celle du nitrure d'aluminium.

De plus, le carbure de silicium est un matériau chimiquement stable, et donc peut enclin à réagir avec le gallium (Ga), ceci jusqu'à des températures supérieures à 1000°C. Ainsi, une couche de carbure de silicium permet de protéger la surface du silicium de toute réaction de gravure du gallium sur cette dernière pendant l'étape de formation de l'au moins une structure semiconductrice comportant du gallium.

De plus, le carbure de silicium sous sa forme amorphe permet, de par l'absence de relation d'épitaxie vis-à-vis de la surface du substrat sur laquelle il est en contact, de relaxer les éventuelles contraintes qui peuvent exister entre la surface de silicium et la structure qui est formée à la surface de la couche de carbure de silicium. Ainsi, une structure formée au moyen d'un tel procédé, présente peu, voire pas, de dislocations malgré la possible présence d'un fort désaccord de maille entre la surface de silicium et le matériau formant la partie de contact de la structure. Ainsi, un tel procédé, en raison du rôle de la couche de carbure de silicium amorphe dans la relaxation des contraintes et pour la protection qu'elle offre pour la surface de silicium, ne nécessite donc pas une longue procédure d'adaptation pour chaque type de structure à former. Un tel procédé est donc bien adapté pour la croissance de structures quel que soit leur type contrairement aux procédés de l'art antérieur pour lesquels la croissance des structures a lieu directement sur une surface de silicium.

L'au moins une structure peut être un fil semiconducteur.

On entend ci-dessus et dans le reste de ce document par fil semiconducteur, une structure semiconductrice présentant 3 dimensions, dont l'une de ces dimensions, dite longitudinale, est au moins 5 fois et préférentiellement, au moins 10 fois, plus importante que la plus grande des deux autres dimensions, qui sont dites latérales. Ainsi, on entend par fil semiconducteur notamment les nano-fils semiconducteurs, c'est-à-dire les fils dont les dimensions latérales sont inférieures ou égales à 100 nm, et les micro-fils semiconducteurs, c'est-à-dire les fils dont les dimensions latérales sont comprises entre 100 nm et 100 µm.

Un tel procédé est particulièrement adapté pour la croissance de fils semiconducteurs en autorisant la possibilité de former un fil présentant un bon contact électrique avec la surface de silicium.

L'épaisseur de la couche de carbure de silicium peut être inférieure à 10 nm et préférentiellement à 5 nm.

Une épaisseur de la couche de carbure de silicium inférieure à 10 nm et préférentiellement inférieure à 5 nm permet de transmettre au travers de la couche de carbure de silicium, malgré son caractère amorphe, l'orientation cristalline de la surface de silicium à l'au moins une structure semiconductrice.

De plus, pour une épaisseur inférieure à 5 nm une partie du contact électrique entre la structure et la surface de silicium est fournie par effet tunnel. Ainsi, il n'est pas nécessaire d'optimiser les conditions de croissance de la couche de carbure de silicium pour s'assurer que la couche de carbure de silicium permette un bon contact entre la structure et la surface de silicium.

L'étape de formation de la couche de carbure de silicium peut comprendre une étape de dépôt chimique sur la surface de silicium semiconducteur, tel qu'un dépôt chimique en phase vapeur assisté par plasma.

De telles méthodes de croissance permettent de fournir des couches carbure de silicium amorphe avec une épaisseur et une composition bien contrôlées.

La partie de contact peut être en nitrure de gallium.

Une structure comportant une partie en nitrure de gallium (GaN) de contact bénéficie particulièrement de l'utilisation d'une couche de carbure de silicium amorphe.

La structure peut être une structure en nitrure de gallium.

Une structure en nitrure de gallium (GaN) bénéficie particulièrement de l'utilisation d'une couche de carbure de silicium amorphe.

L'étape de formation de la couche de carbure de silicium peut comprendre les sous-étapes suivantes :
- dépôt d'une couche épaisse de carbure de silicium amorphe sur au moins une partie de la surface de silicium semiconducteur,
- suppression d'une partie de l'épaisseur de la couche épaisse de carbure de silicium amorphe de manière à former la couche de silicium amorphe.

Une telle procédure de dépôt permet d'obtenir un bon contrôle de l'épaisseur de la couche de carbure de silicium sur toute l'épaisseur de la surface de silicium quelle que soit la taille de cette surface.

La sous-étape de suppression d'une partie de l'épaisseur de la couche de carbure de silicium amorphe peut être obtenue par une méthode mécanique telle que par exemple une procédure de polissage de la couche épaisse de carbure de silicium.

L'étape de formation de l'au moins une structure peut comprendre les sous-étapes suivantes :
- formation d'un masque en contact avec la surface de la couche de carbure de silicium, ledit masque laissant libre au moins une portion de surface de la couche de carbure de silicium qui est dite portion de formation,
- croissance d'au moins une structure en contact avec l'au moins une portion de formation.

Le masque peut comprendre du nitrure de silicium ou de la silice.

Un tel procédé permet une croissance de l'au moins une structure qui soit localisée par la définition de l'au moins une portion de formation. Ainsi, un tel procédé est particulièrement intéressant dans le cas où la structure doit être mise en relation avec d'autres structures ménagées dans le substrat. De plus, avec un tel procédé, le masque, lorsque le matériau le composant est adapté, peut également passiver la partie de la surface du substrat sur laquelle l'au moins une structure n'a pas crû.

L'étape de formation de l'au moins une structure peut comprendre la sous-étape de dépôt d'un premier matériau comportant du gallium dans des conditions de dépôt adaptées pour la formation de structures auto-organisées à la surface de la couche de carbure de silicium.

Un tel procédé de croissance permet de former sur toute la surface de la couche de carbure de silicium les structures semiconductrices permettant ainsi d'obtenir fonctionnalisation de cette dernière en une seule étape.

L'étape de formation de l'au moins une structure peut comprendre les sous-étapes suivantes :
- formation d'un masque en contact avec la couche de carbure de silicium, ledit masque recouvrant au moins une portion de surface de couche de carbure de silicium qui est dite portion de formation, et laissant libre le reste de la couche de carbure de silicium
- suppression sélective de la partie de la couche de carbure de silicium qui est libre de masque, l'au moins une portion de surface de la couche de carbure de silicium restant protégée par le masque,
- suppression du masque de manière à libérer l'au moins une portion,
- croissance d'au moins une structure en contact avec l'au moins une portion de formation.

Un tel procédé permet une croissance de l'au moins une structure qui soit localisée par la définition de l'au moins une portion de formation sans que cette dernière se retrouve recouverte d'un masque. Ainsi, il est possible, après formation de l'au moins une structure à un emplacement parfaitement contrôlé, de former d'autres structures en relation avec l'au moins une structure sans que la formation de ces dernières soit entravée par la présence d'un quelconque masque ou de la couche de carbure de silicium.

La partie de contact de la structure peut être formée dans un premier matériau comportant du gallium, l'étape de formation de l'au moins une structure pouvant comporter une sous-étape de formation d'une couche du premier matériau en contact avec au moins une portion de la couche de carbure de silicium, une portion de ladite couche formant une partie de l'au moins une structure.

Un procédé mettant en oeuvre une couche du premier matériau offre la possibilité de former une structure avec sa partie en contact qui présente un bon contact électrique puisqu'il est obtenu au moyen de la couche du premier matériau.

La partie de contact de la structure peut être formée dans un premier matériau comportant du gallium, L'étape de formation de l'au moins une strucuture pouvant comprendre les sous-étapes suivantes :
- formation d'une couche du premier matériau en contact avec au moins une partie de la couche de carbure de silicium, au moins une portion de ladite partie, dite de formation, étant destinée à former une partie de l'au moins une structure semiconductrice,
- formation d'un masque en contact avec la couche du premier matériau, ledit masque laissant libre l'au moins une portion de surface de couche de matériau qui est dite portion de formation,
- croissance du reste de l'au moins une structure en contact avec l'au moins une portion de formation.

Un tel procédé permet une croissance du reste de l'au moins une structure qui est localisée par la définition de l'au moins une portion de formation. Ainsi, un tel procédé est particulièrement intéressant dans le cas où la structure doit être mise en relation avec d'autres structures ménagées dans le substrat. De plus, avec un tel procédé, le masque, lorsque le matériau le composant est adapté, peut également passiver la surface du substrat sur laquelle l'au moins une structure n'a pas crû. De plus, par l'utilisation d'une couche du premier matériau offre la possibilité de former une structure avec sa partie en contact avec la couche du premier matériau avec une bonne qualité cristallographique puisqu'il est possible de la former par homoépitaxie.

La partie de contact de la structure peut être formée dans un premier matériau comportant du gallium, l'étape de formation de l'au moins une structure pouvant comprendre les sous-étapes suivantes de :
- formation d'une couche du premier matériau en contact avec au moins une partie de la couche de carbure de silicium, et
- dépôt d'un premier matériau comportant du gallium dans des conditions de dépôt adaptées pour la formation de structures auto-organisées à la surface de la couche du premier matériau.

Un tel procédé de croissance permet de former sur toute la surface de la couche de carbure de silicium les structures semiconductrices permettant ainsi d'obtenir la fonctionnalisation de cette dernière surface en une seule étape. De plus, l'utilisation d'une couche du premier matériau offre la possibilité de former la structure avec sa partie en contact avec la couche du premier matériau avec une bonne qualité cristallographique sur toute son épaisseur, celle-ci comportant une étape de croissance par homoépitaxie.

La partie de contact de la structure peut être formée dans un premier matériau comportant du gallium, L'étape de formation de l'au moins une structure pouvant comprendre les sous-étapes suivantes :
- formation d'une couche du premier matériau en contact avec au moins une partie de la couche de carbure de silicium,
- formation d'un masque en contact avec la couche du premier matériau, ledit masque recouvrant au moins une portion de surface de couche du premier matériau qui est dite portion de formation, et laissant libre le reste de la couche de carbure de silicium,
- suppression sélective du reste de la couche du premier matériau et de la couche de carbure de silicium qui est libre de masque, l'au moins une portion de surface de la couche du premier matériau, ainsi que la portion de couche de carbure de silicium que cette dernière portion protège, restant protégée par le masque,
- suppression du masque de manière à libérer l'au moins une portion de formation,
- croissance d'au moins une structure en contact avec l'au moins une portion de formation.

L'invention concerne également un composant semiconducteur comportant :
- un substrat comportant au moins une surface en silicium semiconducteur,
- une couche de carbure de silicium amorphe en contact avec au moins une partie de la surface en silicium semiconducteur,
- au moins une structure semiconductrice en contact avec la couche de carbure de silicium, la partie de la structure en contact avec la couche de carbure de silicium comportant du gallium.

Un tel composant peut être obtenu par un procédé de fabrication ne nécessitant pas une longue procédure d'adaptation lors de sa mise en place ceci avec un contact électrique entre l'au moins un fil et la surface de silicium amélioré par à rapport à celui d'un composant de l'art antérieur comportant une couche de nitrure d'aluminium (AlN).

L'au moins une structure peut être un fil semiconducteur

La couche de carbure de silicium présente une épaisseur inférieure à 10 nm et préférentiellement à 5 nm.

Il peut en outre être prévu une couche d'un premier matériau comportant du gallium, la structure comportant une partie de la couche par laquelle elle est en contact avec la couche de carbure de silicium.

La structure peut comporte un corps en nitrure de gallium par lequel elle est en contact avec la couche de carbure de silicium.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple d'un composant semiconducteur selon un premier mode réalisation de l'invention,
- les figures 2a à 2g illustrent les principales étapes d'un procédé de fabrication d'un composant tel qu'illustré sur la figure 1,
- la figure 3 illustre un composant semiconducteur selon un deuxième mode de réalisation dans lequel il prévu une couche d'un premier matériau en contact avec la couche de carbure de silicium.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La présente invention concerne la fabrication de structures semiconductrice, par exemple de microfils, de nanofils ou d'éléments en forme de pyramide. Dans la suite de ce document, les modes de réalisation décrits concerne la fabrication de microfils ou de nanofils. Toutefois, ces modes de réalisation peuvent être mis en oeuvre pour la fabrication de structures semiconductrices autres que des microfils ou des nanofils, par exemple pour la fabrication de structures tridimensionnelles en forme de pyramide.

Dans l'ensemble de ce document, on entend par fils, nanofils ou microfils semiconducteurs des structures semiconductrices présentant trois dimensions et de forme allongée, dont deux sont du même ordre de grandeur comprises entre une 5 nm et 2,5 µm, la troisième dimension étant au moins égale à 2 fois, 5 fois ou préférentiellement 10 fois la plus grande des deux autres dimensions.

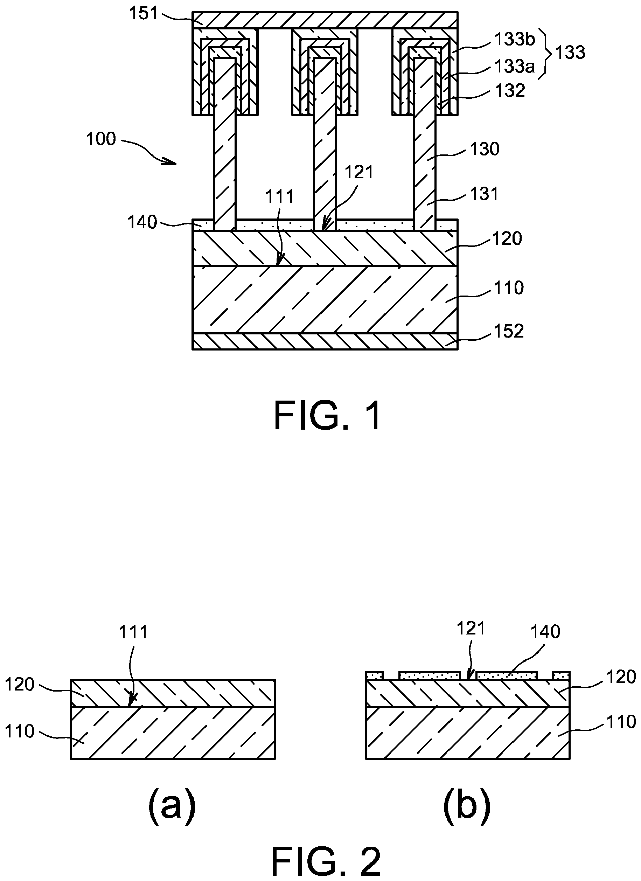

La figure 1 illustre un composant 100 semiconducteur, comportant des structures semiconductrices selon l'invention qui sont des fils semiconducteurs, qui est destiné à l'émission de lumière.

Le composant 100 illustré sur la figure 1 est un composant selon une application particulière de l'invention qui est adapté pour émettre de la lumière dont la longueur d'onde est comprise dans la gamme de longueur d'onde du visible. Les valeurs et les matériaux, lorsqu'ils sont cités en relation avec l'application particulière, ne sont donnés qu'à titre d'exemple et ne sont donc pas limitatifs de l'invention.

Le composant 100 illustré sur la figure 1 comporte :
- un substrat 110 présentant une surface 111 de silicium semiconducteur,
- une couche de carbure de silicium 120 amorphe en contact avec la surface,
- des fils 130 semiconducteurs présentant au moins une partie 131, dite partie de contact, en contact avec la couche de carbure de silicium 120.

Le substrat 110 est un support plan préférentiellement semiconducteur et comportant une surface en silicium 111 semiconducteur. Ainsi, selon une possibilité classique de l'invention, le substrat 110 peut être un substrat en silicium semiconducteur.

Le substrat 110, dans le cas où lors du fonctionnement du composant les fils 130 sont polarisés au travers du substrat 110, présente une concentration en porteur majoritaire d'au moins 10¹⁸ cm⁻³. Le type de conductivité du substrat est un premier type de conductivité.

Ainsi dans l'application particulière le substrat 110 est un substrat plan en silicium dont le type de conductivité est celui pour lequel les porteurs majoritaires sont des électrons. Dans cette même application particulière, la polarisation des fils 130 étant réalisée au travers du substrat 110, la concentration en porteurs majoritaires est d'au moins 10¹⁸ cm⁻³.

La couche de carbure de silicium 120 est en contact avec la surface en silicium 111 et est une couche de carbure de silicium amorphe.

On entend par une couche de carbure de silicium amorphe que la couche de carbure de silicium 120 présente, en correspondance avec la couche elle-même, une figure de diffraction en microscopie d'électron en transmission comportant un ou plusieurs anneaux diffus ou taches diffuses.

On entend ci-dessus, et dans le reste de ce document, par « en correspondance avec la couche en elle même », que les pics de diffraction correspondant à d'autres matériaux que celui de la couche en question, tels que celui du substrat, ne sont pas à prendre en compte pour qualifier la couche de carbure de silicium.

La couche de carbure de silicium 120 présente une épaisseur qui est comprise entre 1 et 100 nm et est préférentiellement comprise entre 1 et 10 nm et encore plus avantageusement entre 1 et 5 nm. Selon une autre possibilité pour laquelle une partie importante de la conductivité entre les fils 130 et le substrat 110 est obtenue par effet tunnel, l'épaisseur de la couche de carbure de silicium 120 est inférieure à 3 nm.

La couche de carbure de silicium 120 peut comporter une concentration en éléments dopants qui sont adaptés pour fournir des porteurs majoritaires correspondant au premier type de conductivité à la couche de carbure de silicium 120. De tels éléments dopants, dans le cas où lors du fonctionnement du composant les fils 130 sont polarisés au travers du substrat 110, sont adaptés pour autoriser un contact ohmique entre le substrat 110 et la partie de contact 131 des fils 130, c'est-à-dire qu'ils fournissent des porteurs majoritaires du premier type de conductivité.

Selon une possibilité alternative ou complémentaire à la présence d'éléments dopants dans la couche de carbure de silicium 120, les porteurs majoritaires de la couche de carbure de silicium 120 peuvent être fournis par les défauts cristallins de la couche de carbure de silicium 120.

Ainsi dans l'application particulière, la couche de carbure de silicium 120 est préférentiellement adaptée pour présenter un type de conductivité pour lequel les porteurs majoritaires sont des électrons. La concentration en porteurs majoritaires de la couche de carbure de silicium 120 est préférentiellement supérieure à 10¹⁸ cm⁻³.

Le composant 100 comporte également, en contact avec la couche de carbure de silicium 120, un masque 140.

Le masque 140 peut être un masque classiquement utilisé dans l'industrie de la microélectronique tel que par exemple un masque en silice SiO₂, en nitrure de silicium du type Si₃N₄ ou du type SiₓNi_{y}, ou encore titane Ti. Le masque 140 est configuré pour recouvrir les zones de la couche de carbure de silicium 120 qui ne sont pas en contact avec les fils 130.

Le masque 140 forme une couche de protection des zones de la couche de carbure de silicium 120 qui ne sont pas en contact avec les fils 130. De manière avantageuse, lorsque le masque 140 est formé dans un matériau adapté, tel que le nitrure de silicium Si₃N₄, il permet également de passiver les zones de la couche de carbure de silicium qui ne sont pas en contact avec les fils 130.

Dans l'application particulière, le masque est préférentiellement dans un nitrure de silicium du type SiₓNi_{y} aléatoire tel que notamment décrit dans le document WO2012/136665.

Les portions 121 de la surface de carbure de silicium 120 qui ne sont pas recouvertes par le masque 140 sont dites portions de formation.

Les fils 130 sont chacun en contact avec la surface de carbure de silicium 120 sur l'une des portions de formation 121 de la surface de carbure de silicium 120. Chaque fil 130, selon la configuration illustrée sur la figure 1, comporte :
- un corps de fil 131 par lequel ils sont en contact avec la couche de carbure de silicium 120, le corps de fil 131 étant du premier type de conductivité,
- une zone active 132, préférentiellement du type non intentionnellement dopé et comportant un système de confinement de porteurs, la dite zone active 132 étant en contact avec le corps de fil 131 au niveau de l'extrémité du corps de fil qui est opposée à la couche de carbure de silicium 120,
- une zone 133 du deuxième type de conductivité en contact avec la zone active 132, de manière à former avec le corps de fil 131 du premier type de conductivité une jonction semiconductrice s'étendant dans la zone active 132.

On entend, ci-dessus et dans le reste de ce document, par zone non intentionnellement dopée que la concentration en porteurs majoritaires dans ladite zone est celle d'un matériau dans lequel on n'a pas intentionnellement introduit d'éléments dopants, c'est-à-dire adaptés pour fournir des porteurs, et qui présente alors une concentration en porteurs majoritaires qui est dite non intentionnellement dopée. La valeur et le type de porteurs dans une zone du type non intentionnellement dopé sont liés au procédé de formation de ladite zone.

Le corps de fil 131 de chacun des fils 130 s'étend longitudinalement à partir de la portion de formation 121 de la couche de carbure de silicium 120 selon une direction sensiblement perpendiculaire à la surface 111 du substrat 110. Les dimensions latérales de chacun des corps de fil 131 correspondent à celle de la portion de formation correspondant audit corps de fil 131.

Ainsi, selon une configuration classique, chaque corps de fil 131 présente une section latérale constante qui peut être, par exemple, circulaire. Le diamètre de la section latérale de chacun des corps de fil est compris entre 5 nm et 2,5 µm. La longueur de chaque corps de fil 131 est comprise entre 50 nm et 50 µm.

Chaque corps de fil 131 est formé dans un premier matériau semiconducteur comportant du gallium Ga, tel que par exemple du nitrure de gallium GaN, de l'arséniure du gallium GaAs ou de l'arséniure d'indium-gallium InₓGa₁₋ₓAs, avec x étant compris entre 0 et 1. Les corps de fil 131 présentent le premier type de conductivité avec préférentiellement une concentration en porteurs majoritaires qui est supérieure à 10¹⁸ cm⁻³.

Le corps de fil 131 de chaque fil 130 forme une partie de contact dudit fil 130.

Dans l'application particulière, chaque corps de fil 131 est en nitrure de gallium GaN. Les corps de fil 131 présentent un type de conductivité pour lequel les porteurs majoritaires sont des électrons. Selon cette même application particulière, la concentration en porteurs majoritaires dans chaque corps est supérieure ou égale à 10¹⁸ cm⁻³.

Chaque zone active 132 est en contact avec l'extrémité du corps de fil 131 correspondant qui est opposée à la couche de carbure de silicium 120. Chaque zone active est en contact sur une partie de la longueur du corps de fil 131 correspondant qui représente une proportion de longueur comprise entre un dixième et la moitié de la longueur totale du corps de fil 131.

Chaque zone active 132 est formée par une couche semiconductrice qui est préférentiellement du type non intentionnellement dopé. Au moins une partie de chacune des zones actives 132, et préférentiellement la totalité de ces dernières, présente un gap direct de manière à autoriser des recombinaisons paires électron-trou radiatives dans la zone active 132. Selon une possibilité particulièrement avantageuse de l'invention, lorsque les fils 130 sont des fils émetteurs de lumière, chacune des zones actives 132 comporte au moins un moyen de confinement pour au moins un type de porteurs tel qu'une pluralité de puits de potentiel.

On entend ci-dessus et dans le reste de ce document par gap direct que le matériau présentant un tel gap direct comporte un maximum d'énergie de sa bande de valence et un minimum d'énergie de sa bande de conduction qui se situent à une valeur du vecteur d'onde k sensiblement également dans le diagramme de dispersion énergétique dudit matériau.

Dans l'application particulière, chaque zone active 132 est formée d'une couche de nitrure de gallium dans laquelle sont aménagées des puits quantiques en arséniure d'indium-gallium du type InₓGa₁₋ₓAs, les dimensions et la proportion x en indium étant adaptés en fonction de la longueur d'onde d'émission du fil 130 correspondant.

Chaque zone 133 du deuxième type de conductivité est en contact avec la zone active 132 correspondant de manière à ce que ladite zone active 132 forme une interface entre les corps de fil 131 et zone 133 correspondant.

Les zones 133 du deuxième type de conductivité sont formées d'au moins une couche semiconductrice du deuxième type de conductivité et sont adaptée pour être contactées électriquement par le biais d'un moyen de polarisation.

Selon la possibilité illustrée sur la figure 1, chacune des zones 133 du deuxième type de conductivité comporte deux couches 133a, 133b semiconductrices, une première couche 133a adaptée pour former avec le corps de fil 131 une jonction semiconductrice dans la zone active 132 et une deuxième couche 133b adaptée pour favoriser un contact ohmique avec un moyen de polarisation. Selon cette même possibilité, lesdites première et deuxième couches 133a, 133b sont toutes deux du premier type de conductivité.

Dans l'application particulière, selon cette même possibilité, les zones 133 du deuxième type de conductivité sont chacune formées par une première couche 133a de nitrure de gallium GaN en contact avec la zone active 132 correspondante qui est en contact elle-même avec une deuxième couche 133b de nitrure d'aluminium-gallium. La première et la deuxième couche 133a, 133b sont toutes deux d'un type de conductivité pour lequel les porteurs majoritaires sont des trous.

Chaque zone 133 est en contact avec un moyen de polarisation adapté pour contacter électriquement ladite zone. Ledit moyen, pour des fils 130 adaptés pour l'émission de lumière, sont adaptés pour contacter électriquement les zones du deuxième type de conductivité tout en laissant passer au moins une partie de la lumière émise dans les zones actives 132. De tels moyens de polarisation peuvent notamment prendre la forme d'une couche semi-transparente, telle qu'une couche d'oxyde indium-étain (plus connu sous son sigle anglais ITO) ou de nickel-or (Ni/Au) complétée par un contact en peigne selon une configuration similaire à celle décrite dans le brevet FR 2 922 685. Bien entendu, l'ensemble des moyens de polarisation adaptés pour contacter électriquement les zones 133 tout en laissant passer au moins une partie de la lumière émise dans les zones actives 132 sont compatible avec cette mise en oeuvre de l'invention.

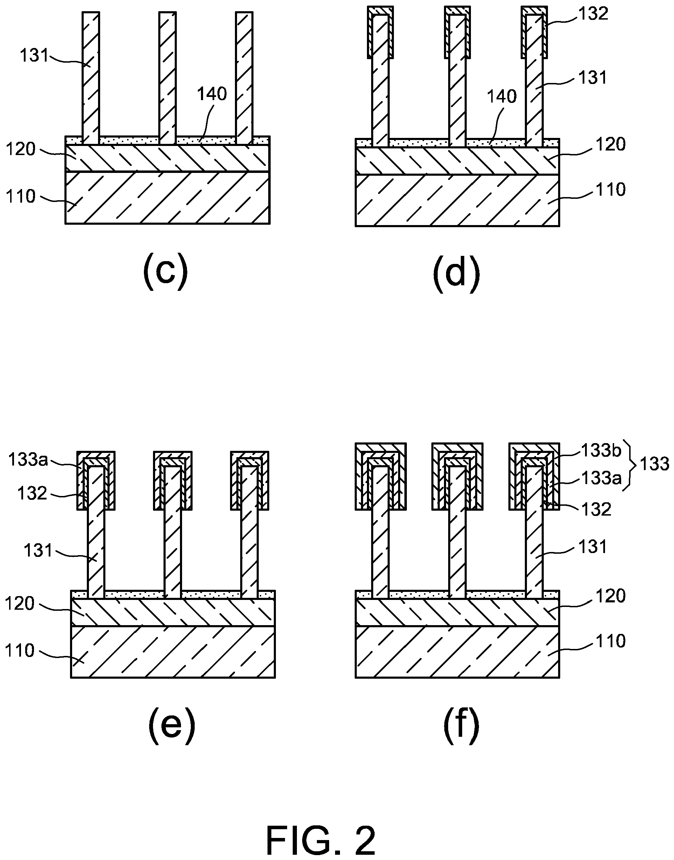

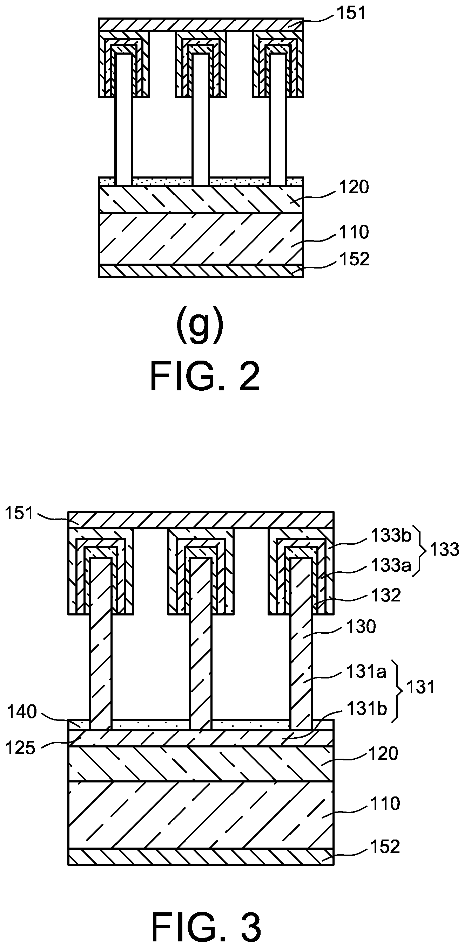

Les figures 2a à 2g illustrent un procédé de fabrication d'un composant tel qu'illustré sur la figure 1. Un tel procédé comporte les étapes suivantes de :
- fourniture d'un substrat 110 semiconducteur,
- formation d'une couche de carbure de silicium 120 amorphe en contact avec la surface du support semiconducteur, comme cela est illustré sur la figure 2a,
- formation d'un masque dur 140 en nitrure de silicium ou en dioxyde de silicium en contact avec la surface de la couche de carbure de silicium 120 qui est opposée au substrat 110, le masque dur 140 étant adapté pour laisser libre uniquement les portions de formation 121 de la couche de carbure de silicium 120, comme cela est illustré sur la figure 2b,
- croissance des corps de fil 131 chacun en contact avec une portion de formation 121 de la couche de carbure de silicium 120, la croissance en dehors des portions de formation 121 étant inhibée par le masque dur 140, les corps de fil 130 étant réalisés dans un premier matériau semiconducteur comportant du gallium Ga, comme cela est illustré sur la figure 2c,
- formation d'une couche semiconductrice 132 au niveau de l'extrémité des corps de fil 130 qui est opposée à la couche de carbure de silicium 120 afin de former la zone active 132, ladite couche 132 comportant des puits quantiques, comme cela est illustré sur la figure 2d,
- formation des premières couches 133a du deuxième type de conductivité en contact chacune avec une zone active 132 correspondante, chacune des premières couches étant adaptée pour former avec le corps de fil 131 correspondant une jonction semiconductrice s'étendant dans ladite zone active 132, comme cela est illustré sur la figure 2e,
- formation des deuxièmes couches 133b du deuxième type de conductivité en contact chacune avec une première couche 133a correspondante, chacune des deuxièmes couches 133b étant adaptée pour former un contact ohmique avec un moyen de polarisation, comme cela est illustré sur la figure 2f,
- formation d'un moyen de polarisation en contact avec chacune des deuxièmes couches 133b, ledit moyen de polarisation étant adapté pour contacter électriquement les zones 133 du deuxième type de conductivité tout en laissant passer au moins une partie de la lumière émise dans les zones actives 132, comme cela est illustré sur la figure 2g.

Lors de l'étape de formation de la couche de carbure de silicium 120, cette dernière peut être formée par exemple lors d'un dépôt en voie physique de carbure de silicium obtenu, tel que par pulvérisation cathodique du type radiofréquence. Une telle méthode de dépôt est notamment décrite dans la publication de Magafas et al publié en 2007 dans la revue scientifique « Journal of Non-Crystalline Solids », volume 353, pages 1065 à 1969.

Selon une possibilité non illustrée de la l'invention, l'étape de formation de la couche de carbure de silicium 120 peut comprendre les sous-étapes suivantes :
- dépôt d'une couche épaisse de carbure de silicium amorphe sur au moins une partie de la surface du substrat,
- suppression d'une partie de l'épaisseur de la couche épaisse de carbure de silicium amorphe de manière à former la couche de carbure de silicium 120 amorphe.

Selon cette même possibilité, la sous-étape de suppression d'une partie de l'épaisseur de la couche épaisse de carbure de silicium amorphe peut être obtenue par une méthode mécanique telle que par exemple une procédure de polissage de la couche épaisse de carbure de silicium. Cette même sous-étape peut également être obtenue par une méthode chimique telle que par exemple par gravure par ions réactifs.

Lors de l'étape de croissance des corps de fil 131, en fonction de la méthode utilisée pour cette croissance, le substrat 110 et la couche de carbure de silicium 120 peuvent être soumis à des températures suffisamment importante pour partiellement cristalliser la couche de carbure de silicium 120. Ainsi, malgré une couche de carbure de silicium 120 qui est formée amorphe, cette dernière peut, dans le composant final, comporter en outre des zones cristallines.

Dans le cas de polycristaux les zones cristallines présentent au moins deux zones comportant soit des orientations cristallines différentes l'une de l'autre soit des polytypes de carbure de silicium différents, chaque zone formant un grain cristallin différent.

Dans un tel cas où la couche de carbure de silicium amorphe comporte quelques zones cristallines, la figure de diffraction en microscopie d'électron en transmission correspondante présente des taches de diffraction associées aux cristaux ainsi qu'un ou plusieurs anneaux diffus ou taches diffuses associées aux parties amorphes.

La figure 3 illustre un composant 100 selon un deuxième mode de réalisation de l'invention. Un tel composant se différencie d'un composant selon le premier mode de réalisation en ce qu'il comprend en outre une couche semiconductrice 125 comportant du gallium (Ga) en contact avec la couche de carbure de silicium 120, chaque fil comportant une portion 131b de ladite couche semiconductrice 125.

Un composant 100 selon cette possibilité comprend donc une couche semiconductrice 125 d'un premier matériau semiconducteur comportant du gallium en contact avec la couche de carbure de silicium 120 sur sa face qui est opposée au substrat 110. Dans ce mode de réalisation la couche semiconductrice 125 présente une épaisseur comprise entre 1 et 5 nm. La couche semiconductrice 125 présente le premier type de conductivité et comporte une concentration en porteurs majoritaires suffisante pour assurer un bon contact électrique avec la couche de carbure de silicium 120.

Chaque corps de fil 131 comporte la portion 131b de la couche semiconductrice 125 qui est comprise entre la couche de carbure de silicium 120 et le reste 131a du corps de fil 131 correspondant. La couche semiconductrice 125 et les corps de fil 131b sont réalisés dans le premier matériau semiconducteur.

La couche semiconductrice 125 et les corps de fil 131b présentent le premier type de conductivité. La concentration en porteurs majoritaires de la couche semiconductrice 125 et des corps de fil 131b est adaptée pour fournir un contact ohmique avec le substrat au travers de la couche de carbure de silicium 120. Ainsi la couche semiconductrice 125 et les corps de fil 131b présentent préférentiellement une concentration en porteurs majoritaires supérieure à 10¹⁸ cm⁻³.

Dans l'application particulière, le premier matériau est du nitrure de gallium. La couche semiconductrice 125 et les corps de fil 131b présentent un type de conductivité pour lequel les porteurs majoritaires sont des électrons. La couche semiconductrice 125 et les corps de fil 131b présentent une concentration en porteurs majoritaires préférentiellement supérieure à 10¹⁸ cm⁻³.

Un procédé de fabrication d'un composant 100 selon ce deuxième mode de réalisation se différencie d'un procédé de fabrication d'un composant 100 selon ce deuxième mode de réalisation en ce que l'étape de formation des corps de fil 131 semiconducteurs comprend les sous-étapes suivantes :
- former une couche semiconductrice 125 comportant du gallium en contact avec la couche de carbure de silicium 120,
- former le reste du corps de fil 131b en contact avec la couche semiconductrice 125 de manière à ce que les corps de fil 131 comportent les portions 131b de la couche semiconductrice 125 comprises entre chacun des corps de fil 131 et la couche de carbure de silicium 120.

Si, dans les modes de réalisation décrits ci-dessus les structures décrites sont des fils semiconducteurs présentant une configuration coquille, c'est-à-dire une zone active recouvrant l'extrémité d'un corps de fil longitudinal telle qu'illustrée sur la figure 1, l'invention n'est pas limitée à cette seule configuration et concerne également les structures présentant un autre type de configuration. Ainsi, l'invention couvre également les autres types de structures semiconductrices tels que les fils semiconducteurs présentant une configuration filaire, c'est-à-dire présentant une jonction sur un plan perpendiculaire à l'axe du fil, ou les structures du type pyramidal.

Dans l'ensemble des modes de réalisation décrits ci-dessus, l'étape de croissance des structures est réalisée au moyen d'un masque par croissance de fils sur des portions de surface libres de masque, la croissance des fils sur le reste de la surface étant inhibée par la présence du masque. Néanmoins, les structures, qu'elles soient des fils ou non, peuvent être obtenues également par une étape de croissance d'un autre type sans que l'on sorte du cadre de l'invention.

Ainsi par exemple, les structures peuvent être formées, ceci sans que l'on sorte du cadre de l'invention, par un procédé comportant une étape de dépôt d'un premier matériau comportant du gallium dans des conditions de dépôt adaptées pour la formation de structures auto-organisées à la surface de la couche de carbure de silicium. Le procédé peut également comporter les étapes suivantes :
- formation d'un masque en contact avec la couche de carbure de silicium, ledit masque recouvrant au moins une portion de surface de couche de carbure de silicium qui est dite portion de formation, et laissant libre le reste de la couche de carbure de silicium
- suppression sélective du reste de la couche de carbure de silicium qui est libre de masque, l'au moins une portion de surface de la couche de carbure de silicium restant protégée par le masque,
- suppression du masque de manière à libérer l'au moins une portion,
- croissance d'au moins une structure en contact avec l'au moins une portion de formation.

Selon cette même possibilité, et ceci également sans que l'on sorte du cadre de l'invention, le procédé peut comprendre les étapes suivantes :
- formation d'une couche du premier matériau en contact avec au moins une partie de la couche de carbure de silicium, au moins une portion de ladite partie, dite de formation, étant destinée à former une partie de l'au moins une structure semiconductrice,
- formation d'un masque en contact avec la couche du premier matériau, ledit masque laissant libre l'au moins une portion de surface de couche de matériau qui est dite portion de formation,
- croissance du reste de l'au moins un fil en contact avec l'au moins une portion de formation.

## Revendications

1. Procédé de fabrication d'au moins une structure semiconductrice comportant les étapes suivantes :
- fourniture d'un substrat (110) comportant au moins une surface de silicium (111) semiconducteur,
- formation d'une couche de carbure de silicium (120) amorphe en contact avec au moins une partie de la surface de silicium (111) semiconducteur,
- formation de l'au moins une structure semiconductrice en contact avec la couche de carbure de silicium (120), ladite structure comportant au moins une partie, qui est dite partie de contact, en contact avec la surface de la couche de carbure de silicium (120), qui comporte du gallium.

2. Procédé selon la revendication 1, dans lequel l'au moins une structure est un fil semiconducteur (130).

3. Procédé de fabrication selon la revendication 1 ou 2, dans lequel l'épaisseur de la couche de carbure de silicium (120) est inférieure à 10 nm et préférentiellement à 5 nm.

4. Procédé de fabrication selon l'une quelconque des revendications précédentes, dans lequel l'étape de formation de la couche de carbure de silicium (120) comprend une étape de dépôt chimique sur la surface de silicium (111) semiconducteur tel qu'un dépôt chimique en phase vapeur assisté par plasma.

5. Procédé de fabrication selon l'une quelconque des revendications précédentes dans lequel la partie de contact est en nitrure de gallium.

6. Procédé de fabrication selon l'une quelconque des revendications précédentes, dans lequel l'étape de formation de la couche de carbure de silicium (120) comprend les sous-étapes suivantes :
- dépôt d'une couche épaisse de carbure de silicium amorphe sur au moins une partie de la surface de silicium semiconducteur,
- suppression d'une partie de l'épaisseur de la couche épaisse de carbure de silicium amorphe de manière à former la couche de silicium amorphe (120).

7. Procédé de fabrication selon l'une quelconque des revendications précédentes, dans laquelle l'étape de formation de l'au moins une structure semiconductrice comprend les sous-étapes suivantes :
- formation d'un masque (140) en contact avec la surface de la couche de carbure de silicium (120), ledit masque laissant libre au moins une portion (121) de surface de la couche de carbure de silicium (120) qui est dite portion de formation,
- croissance d'au moins une structure en contact avec l'au moins une portion de formation (121).

8. Procédé de fabrication selon l'une quelconque des revendications 1 à 5, dans lequel la partie de contact de la structure est formée dans un premier matériau comportant du gallium, l'étape de formation de l'au moins une structure comportant une sous-étape de formation d'une couche (125) du premier matériau.

9. Composant (100) semiconducteur **caractérisé en ce qu**'il comporte :
- un substrat (110) comportant au moins une surface en silicium (111) semiconducteur,
- une couche de carbure de silicium (120) amorphe en contact avec au moins une partie de la surface en silicium semiconducteur,
- au moins une structure semiconductrice en contact avec la couche de carbure de silicium (120), la partie de la structure en contact avec la couche de carbure de silicium (120) comportant du gallium.

10. Composant (100) selon la revendication précédente, dans lequel l'au moins une structure est un fil semiconducteur (130).

11. Composant (100) selon la revendication 9 ou 10, dans lequel la couche de carbure de silicium (120) présente une épaisseur inférieure à 10 nm et préférentiellement à 5 nm.

12. Composant (100) selon l'une des revendications 9 à 11, dans lequel il est en outre prévu une couche (125) d'un premier matériau comportant du gallium, la structure comportant une partie (131b) de la couche (125) par laquelle elle est en contact avec la couche de carbure de silicium (120).

13. Composant (100) selon l'une quelconque des revendications 9 à 11, dans laquelle la structure comporte un corps en nitrure de gallium par lequel il est en contact avec la couche de carbure de silicium (120).

## Patentansprüche

1. Verfahren zur Herstellung wenigstens einer Halbleiterstruktur, umfassend die folgenden Schritte:
- Bereitstellen eines Substrats (110), das wenigstens eine Halbleiter-Siliziumoberfläche (111) umfasst,
- Bilden einer Schicht aus amorphem Siliziumkarbid (120) in Kontakt mit wenigstens einem Teil der Halbleiter-Siliziumoberfläche (111),
- Bilden wenigstens einer Halbleiterstruktur in Kontakt mit der Schicht aus Siliziumkarbid (120), wobei die Struktur wenigstens einen Teil, genannt Kontaktteil, in Kontakt mit der Oberfläche der Schicht aus Siliziumkarbid (120) umfasst, der Gallium enthält.

2. Verfahren nach Anspruch 1, bei dem die wenigstens eine Struktur ein Halbleiterdraht (130) ist.

3. Verfahren zur Herstellung nach Anspruch 1 oder 2, bei dem die Dicke der Schicht aus Siliziumkarbid (120) kleiner als 10 nm und vorzugsweise als 5 nm ist.

4. Verfahren zur Herstellung nach einem der vorhergehenden Ansprüche, bei dem der Schritt des Bildens der Schicht aus Siliziumkarbid (120) einen Schritt der chemischen Abscheidung auf der Halbleiter-Siliziumoberfläche (111) umfasst, beispielsweise eine plasmaunterstützte chemische Dampfphasenabscheidung.

5. Verfahren zur Herstellung nach einem der vorhergehenden Ansprüche, bei dem der Kontaktteil aus Galliumnitrid ist.

6. Verfahren zur Herstellung nach einem der vorhergehenden Ansprüche, bei dem der Schritt des Bildens der Schicht aus Siliziumkarbid (120) die folgenden Teilschritte umfasst:
- Abscheiden einer dicken Schicht aus amorphem Siliziumkarbid auf wenigstens einem Teil der Halbleiter-Siliziumoberfläche,
- Entfernen eines Teils der Dicke der dicken Schicht aus amorphem Siliziumkarbid derart, dass die Schicht aus amorphem Silizium (120) gebildet wird.

7. Verfahren zur Herstellung nach einem der vorhergehenden Ansprüche, bei dem der Schritt des Bildens der wenigstens einen Halbleiterstruktur die folgenden Teilschritte umfasst:
- Bilden einer Maske (140) in Kontakt mit der Oberfläche der Schicht aus Siliziumkarbid (120), wobei die Maske wenigstens einen Bereich (121) der Oberfläche der Schicht aus Siliziumkarbid (120) frei lässt, genannt Bildungsbereich,
- Aufwachsen wenigstens einer Struktur in Kontakt mit dem wenigstens einen Bildungsbereich (121).

8. Verfahren zur Herstellung nach einem der Ansprüche 1 bis 5, bei dem der Kontaktteil der Struktur aus einem ersten Material gebildet wird, das Gallium enthält, wobei der Schritt des Bildens der wenigstens einen Struktur einen Teilschritt des Bildens einer Schicht (125) aus dem ersten Material umfasst.

9. Halbleiterkomponente (100), **dadurch gekennzeichnet, dass** sie umfasst:
- ein Substrat (110), das wenigstens eine Halbleiter-Siliziumoberfläche (111) umfasst,
- eine Schicht aus amorphem Siliziumkarbid (120) in Kontakt mit wenigstens einem Teil der Halbleiter-Siliziumoberfläche,
- wenigstens eine Halbleiterstruktur in Kontakt mit der Schicht aus Siliziumkarbid (120), wobei der Teil der Struktur in Kontakt mit der Schicht aus Siliziumkarbid (120) Gallium enthält.

10. Komponente (100) nach dem vorhergehenden Anspruch, bei dem die wenigstens eine Struktur ein Halbleiterdraht (130) ist.

11. Komponente (100) nach Anspruch 9 oder 10, wobei die Schicht aus Siliziumkarbid (120) eine Dicke von weniger als 10 nm und vorzugsweise als 5nm aufweist.

12. Komponente (100) nach einem der Ansprüche 9 bis 11, wobei ferner eine Schicht (125) aus einem ersten Material vorgesehen ist, das Gallium enthält, wobei die Struktur einen Teil (131 b) der Schicht (125) umfasst, durch den sie in Kontakt mit der Schicht aus Siliziumkarbid (120) ist.

13. Komponente (100) nach einem der Ansprüche 9 bis 11, wobei die Struktur einen Körper aus Galliumnitrid umfasst, durch den sie in Kontakt mit der Schicht aus Siliziumkarbid (120) ist.

## Claims

1. A method for manufacturing at least one semiconductor structure comprising the following steps of:
- providing a substrate (110) including at least one semiconductor silicon surface (111),
- forming an amorphous silicon carbide layer (120) in contact with at least one part of the semiconductor silicon surface (111),
- forming the at least one semiconductor structure in contact with the silicon carbide layer (120), said structure comprising at least one part, called a contact part, in contact with the surface of the silicon carbide layer (120), which includes gallium.

2. The method according to claim 1, wherein the at least one structure is a semiconductor wire (130).

3. The manufacturing method according to claim 1 or 2, wherein the thickness of the silicon carbide layer (120) is lower than 10 nm and preferentially than 5 nm.

4. The manufacturing method according to any of the preceding claims, wherein the step of forming the silicon carbide layer (120) comprises a step of chemical deposition on the semiconductor silicon surface (111) such as a plasma enhanced chemical vapor deposition.

5. The manufacturing method according to any of the preceding claims, wherein la contact part is of gallium nitride.

6. The manufacturing method according to any of the preceding claims, wherein the step of forming the silicon carbide layer (120) comprises the following sub-steps of:
- depositing a thick amorphous silicon carbide layer on at least one part of the semiconductor silicon surface,
- removing a part of the thickness of the thick amorphous silicon carbide layer so as to form the amorphous silicon layer (120).

7. The manufacturing method according to any of the preceding claims, wherein the step of forming the at least one semiconductor structure comprises the following sub-steps of:
- forming a mask (140) in contact with the surface of the silicon carbide layer (120), said mask leaving free at least one surface portion (121) of the silicon carbide layer (120) which is called formation portion,
- growing at least one structure in contact with the at least one formation portion (121).

8. The manufacturing method according to any of claims 1 to 5, wherein the contact part of the structure is formed of a first material comprising gallium, the step of forming the at least one structure including a sub-step of forming a layer (125) with the first material.

9. A semiconductor component (100) **characterized in that** it comprises:
- a substrate (110) including at least one semiconductor silicon surface (111),
- an amorphous silicon carbide layer (120) in contact with at least one part of the semiconductor silicon surface,
- at least one semiconductor structure in contact with the silicon carbide layer (120), the part of the structure in contact with the silicon carbide layer (120) including gallium.

10. The component (100) according to the preceding claim, wherein the at least one structure is a semiconductor wire (130).

11. The component (100) according to claim 9 or 10, wherein the silicon carbide layer (120) has a thickness lower than 10 nm and preferentially than 5 nm.

12. The component (100) according to one of claims 9 to 11, wherein a layer (125) of a first material comprising gallium is further provided, the structure comprising a part (131b) of the layer (125) by which it is in contact with the silicon carbide layer (120).

13. The component (100) according to any of claims 9 to 11, wherein the structure comprises a body of gallium nitride by which it is in contact with the silicon carbide layer (120).
